(19) Europäisches Patentamt

European Patent Office

Office européen des brevets

(11) EP 0 454 172 B1

# EUROPEAN PATENT SPECIFICATION

(12)

(45) Date of publication and mention
of the grant of the patent:
**27.12.1996 Bulletin 1996/52**

(51) Int Cl.6: **H01B 3/12**, C04B 35/46

(21) Application number: **91106911.0**

(22) Date of filing: **29.04.1991**

(54) **Dielectric ceramic composition**

Dielektrische keramische Zusammensetzung

Composition céramique diélectrique

(84) Designated Contracting States:
**DE GB**

(30) Priority: **27.04.1990 JP 114123/90**

(43) Date of publication of application:
**30.10.1991 Bulletin 1991/44**

(73) Proprietor: **KYOCERA CORPORATION
Yamashina-ku Kyoto-shi (JP)**

(72) Inventors:
* **Utaki, Hideki, c/o Kyocera Corporation
Kagoshima-ken (JP)**
* **Nishi, Toyomi, c/o Kyocera Corporation
Kagoshima-ken (JP)**
* **Fujikawa, Nobuyoshi, c/o Kyocera Corporation
Kagoshima-ken (JP)**

(74) Representative: **Vogeser, Werner, Dipl.-Ing. et al
Patent- und Rechtsanwälte
Hansmann, Vogeser, Dr. Boecker,
Alber, Dr. Strych, Liedl
Albert-Rosshaupter-Strasse 65
81369 München (DE)**

(56) References cited:
**JP-B- 5 531 963**

* **JOURNAL OF THE AMERICAN CERAMIC
SOCIETY, vol. 43, No. 11, November 1960, S.
MARZULLO et al. "Some Ceramic Dielectrics
with a Very Low Temperature Coefficient of
Capacitance" page 609**

**Description**

<u>Background of the Invention</u>

(1) Field of the invention

The present invention relates to a novel dielectric ceramic composition adapted to be used as a material of resonators and circuit board in the microwave frequency band. More specifically, the invention relates to a dielectric ceramic composition which contains MgO, $La_2O_3$ and $TlO_2$ in particular composition ratios.

(2) Description of the Prior Art

In the recent years, dielectric ceramics have been extensively used in the microwave applications as represented by microwave integrated circuitry, wide-spreac use of gun oscillators, and employment of gallium arsenide field-effect transistors for the oscillators accompanying the trend toward practically using mobile telephones, cordless telephones, personal wireless devices, satellite broadcast receivers, ect.

The dielectric ceramics for microwave applications are mainly used in the resonators and must satisfy the following three principal characteristics, i.e., (1) a large dielectric constant despite a decrease in the size, since the wavelength is contracted to $1/\varepsilon r^{1/2}$ in the dielectric, (2) a small dielectric loss (large Q value) at high frequencies, and (3) a small temperature coefficient of the resonance frequency, i.e., a small or stable temperature coefficient of the dielectric constant.

Conventional examples of the dielectric ceramics of this kind include a $BaO\text{-}TiO_2$ type material, $BaO\text{-}REO\text{-}TiO_2$ (where REO denotes an oxide of a rare earth oxide, and used throughout the specification) type material, a complex crystal structure type material in which the B site is constituted by a plurality of elements, and an $MgTiO_3\text{-}CaTiO_3$ type material.

The $BaO\text{-}TiO_2$ type material exhibits a dielectric constant $\varepsilon r$ of as high as 38 to 40 and a dielectric loss $\tan \delta$ of as low as $2.0 \times 10^{-4}$ but makes it difficult to obtain a resonance frequency with zero temperature coefficient $\tau f$ on a single phase. Moreover, the dielectric constant and the temperature dependency of the dielectric constant change greatly with a change in the composition, making it difficult to decrease and stabilize the temperature coefficient $\tau f$ of the resonance frequency while maintaining a high dielectric constant and a small dielectric loss.

Examples of the $BaO\text{-}REO\text{-}TiO_2$ type material may include a $BaO\text{-}Nd_2O_3\text{-}TiO_2$ type material or a $BaO\text{-}Sm_2O_3\text{-}TiO_2$ type material which exhibit a dielectric constant $\varepsilon r$ of as very high as 40 to 60, and these materials exhibit a zero temperature coefficient $\tau f$ of the resonance frequency, though their Q value is smaller than 2000, in other words, their dielectric loss $\tan \delta$ is as high as $5.0 \times 10^{-4}$ or more.

The composite perovskite type material exhibits very excellent dielectric characteristics as represented by $Ba(Zn_{1/3}Ta_{2/3})O_2$ but uses such expensive materials as $Nb_2O_5$ and $Ta_2O_5$ in large amounts to drive up the cost of material. Furthermore, the $MgTiO_3\text{-}CaTiO_3$ type material exhibits a Q value which is greater than 5000 and the temperature coefficient $\tau f$ of resonance frequency which is zero, but exhibits the dielectric constant which is as small as 16 to 25.

As described above, none of the above-mentioned materials fully satisfy the above three characteristics that are required for the dielectric material for high-frequency applications.

From Journal of the American Ceramic Society, <u>43</u>, no. 11, 1960, p. 609, dielectric ceramic compositions of the $MgO\text{-}La_2O_3\text{-}TiO_2$ and $MgO\text{-}Nd_2O_3\text{-}TiO_2$ system are known. According to said document the temperature coefficient value of capacitance should be small. The known ceramics are described as a capacitor material.

JP-B2-55-31963 describes ceramic compositions of the $MgO\text{-}La_2O_3\text{-}MnO_2$ system. The known ceramic composition is used as a capacitor material for the compensation of temperatures and does not relate to dielectric ceramic compositions for resonator use.

<u>Summary of the Invention</u>

By the present invention the above-mentioned problems should be solved and a dielectric ceramic composition for microwave applications having a suitable specific inductivity, a large Q value and small temperature dependency of resonance frequency should be provided. Concretely speaking, the invention provides a dielectric ceramic composition having a dielectric constant of more than 22, a Q value of more than 1000, and $\tau f$ of not more than $\pm 170$ ppm/°C.

The present inventors have proceeded with the study in connection with the above-mentioned respects and have found that the above object can be achieved if the composition consists of MgO, $La_2O_3$ and $TiO_2$ at ratios within a predetermined range, and if $MnO_2$ is further added to this composition.

According to the present invention, there is provided a dielectric ceramic composition for resonator use which has a composition expressed by the formula (A) which is based on oxides of three components

$$xMgO \cdot yLa_2O_3 \cdot zTiO_2 \tag{A}$$

wherein x, y and z are numerals which represent said components in mole% and which further satisfy,

$$x + y + z = 100 \tag{1}$$

$$y \leq -0.79487x + 28.718 \tag{2}$$

$$y \leq -0.26667x + 20.267 \tag{3}$$

$$y \leq 11x + 9 \tag{4}$$

$$y \geq -0.51852x + 14.759 \tag{5}$$

and

$$y \geq 0.5 \tag{6}$$

and said ceramic composition contains a crystalline phase, as a main crystalline phase, consisting of $La_4Ti_9O_{24}$ and $Mg\,Ti_2O_5$ in combination and has a Q value of greater than 1000 in microwave frequency bands.

According to the present invention, there is provided a dielectric ceramic composition which contains 0.01 to 3% by weight of $MnO_2$ with respect to the main components expressed by the above formula (A).

Brief Description of the Drawing

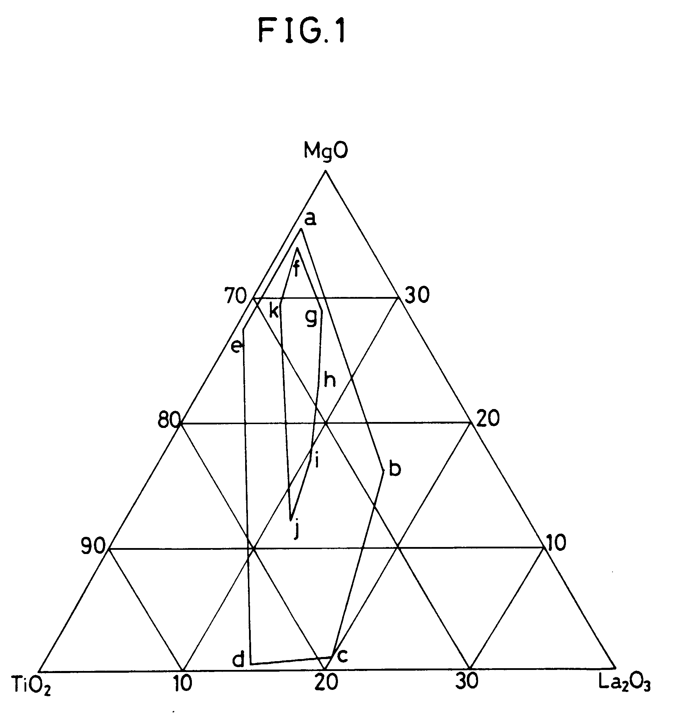

Fig. 1 is a ternary diagram of the $MgO$-$La_2O_3$-$TiO_2$ system explaining the composition range of a dielectric ceramic composition of the present invention.

Detailed Description of the Preferred Embodiment

The composition of the present invention lies within a region surrounded by a line that connects the points a, b, c, d and e in this order in the diagram of ternary system $MgO$-$La_2O_2$-$TiO_3$ of Fig. 1, and wherein the compositions at each of the points are expressed as follows:

|   | x | y | z |
|---|---|---|---|
| a | 35.5 | 0.5 | 64.0 |
| b | 16.0 | 16.0 | 68.0 |
| c | 1.0 | 20.0 | 79.0 |
| d | 0.5 | 14.5 | 85.0 |
| e | 27.5 | 0.5 | 72.0 |

From these coordinate values, the composition ratios of the present invention are expressed by the above equation and inequalities (1) to (6). The inequality (2) corresponds to a straight line a-b, (3) corresponds to a straight line b-c, (4) corresponds to a straight line c-d, (5) corresponds to a straight line d-e, and (6) corresponds to a straight line e-a.

As described above, the dielectric ceramic composition of the present invention is composed of $MgO$, $La_2O_3$ and $TiO_2$ as chief components. The reason why the composition is limited to lie within the above-mentioned ranges is because the Q value becomes smaller than 1000 when $TiO_2$ becomes smaller than a line connecting the points a-b-c, the composition is poorly sintered when $MgO$ becomes smaller than a line connecting the points c-d, $\tau f$ becomes greater than 170 ppm/°C when $TiO_2$ becomes greater than a line connecting the points d-e, and the composition is

poorly sintered when $La_2O_3$ becomes smaller than a line connecting the points e-a.

More excellent properties are exhibited if the composition of the present invention is limited to lie within a range surrounded by points f-g-h-i-j-k-f in the ternary diagram of Fig. 1. The region surrounded by these lines are expressed by the following inequalities

$$fg: y \leqq -0.8302x + 29.2268 \tag{7}$$

$$gh: y \leqq -0.4717x + 19.9378 \tag{8}$$

$$hi: y \leqq -0.3871x + 16.9581 \tag{9}$$

$$ij: y \leqq -0.24x + 14.428 \tag{10}$$

$$jk: y \geqq -0.5429x + 18.1234 \tag{11}$$

and

$$kf: y \geqq -0.2326x + 8.9082 \tag{12}$$

It is also possible to further increase the Q value of the composition by adding $MnO_2$ to the $MgO$-$La_2O_3$-$TiO_2$. However, a distinguishing effect is not obtained if the amount of $MnO_2$ is smaller than 0.01% by weight, and the dielectric constant decreases if the amount of $MnO_2$ exceeds 3.0% by weight. It is desired that $MnO_2$ is added in an amount of 0.1 to 1.0 % by weight.

To produce the ceramic according to the present invention, powders of metal oxides constituting the ceramic, i.e., powders of $MgO$, $La_2O_3$, $TiO_2$ and $MnO_2$, are weighed and mixed together, or compounds such as carbonate, nitrate and sulfate that are capable of forming oxides upon baking, are weighed and mixed together, and are then calcined at 950° to 1150°C as required. Then, the mixed powder or the calcined powder is molded by a customary molding method and is fired at a temperature of 1250° to 1400°C in the air.

In the thus obtained dielectric ceramic are formed crystals that contain at least one phase among the five crystalline phases of $TiO_2$, $La_4Ti_9O_{24}$, $MgTiO_2O_5$, $La_{0.66}TiO_{2.993}$ and $La_2Ti_2O_7$. Among these crystalline phases, it is desired that $La_4Ti_9O_{24}$, $MgTi_2O_5$ or $La_{0.66}TiO_{2.993}$ exists as a main crystalline phase, and it is particularly desired that both $La_4Ti_9O_{24}$ and $MgTi_2O_5$ exist together to constitute the main crystalline phase.

The dielectric ceramic composition of the present invention of the type of $MgO$-$La_2O_3$-$TiO_2$ exhibits dielectric characteristics of a small $\tau f$ and a large Q value at high-frequency regions as a result of limiting the composition within a particular range. The dielectric constant and $\tau f$ can, further, be freely changed by changing the composition ratio of the three components within the above range.

The distinguishing feature of the dielectric ceramic composition of the present invention is that it exhibits a dielectric constant ($\varepsilon r$) of greater than 22 and, particularly, from 22 to 33, a Q value of greater than 1000 and, particularly, from 2000 to 7000, and a $\tau f$ of -170 ppm/°C to +170 ppm/°C and, particularly -30 ppm/°C to +30 ppm/°C.

Therefore, the dielectric ceramic composition of the present invention can be sufficiently used as a material for resonators and circuit boards in highfrequency bands such as in microwave frequency bands.

The dielectric ceramic composition of the present invention can be applied to resonators, substrates and the like which are used mainly in a microwave band.

Specifically, these resonators can select a given signal by being resonated at only a given frequency. The resonators may include, for example, a dielectric resonator comprising a rod element formed of an dielectric material and supported within a metallic container, which is operated in a TE (01δ) mode, a coaxial resonator comprising a rod element having a cavity therein and formed with electrodes on the inner and outer peripheries thereof, which is operated in a TEM mode and a strip line resonator comprising a rectangular parallelepiped, a grounded electrode formed over the entire of one side and a strip line having a given shape formed in the opposite side, which is operated in a TEM mode.

The electrodes and lines used in the resonators may be formed by coating the element with an electrically conductive paste such as Au, Ag, Cu, Al, Ni, Cr, Pt and Pd on the surface thereof and baking the paste thereon, or simultaneously calcinating the paste together with ceramics, or thin film forming techniques such as plating and PVD method.

(Embodiments)

The invention will now be described by way of embodiments.

Embodiment 1

Powders of starting materials consisting of MgO, $La_2O_3$ and $TiO_2$ were weighed at ratios of Table 1, and were mixed together for 20 hours using a ball mill while adding pure thereto. The slurry was dried and calcined at 1100°C for two hours. The calcined mixed powder was pulverized again using the ball mill for 20 hours, and the slurry thereof was dried. The obtained dry powder was admixed with about 1% by weight of a binder, molded under a pressure of about 1 ton/cm$^2$, and was fired at 1250° to 1200°C for two hours in the air to obtain rod samples that are about 14 mm in diameter x 7 mm in thickness.

The samples were measured for their dielectric constant εr, Q value and τf at a resonance frequency (f) of 3.5 to 6.0 GHz in compliance with the dielectric cylindrical resonator method. The Q values were converted into those of at 5 GHz based upon Q x f = constant. The temperature coefficients τf were measured over a range of -40° to +85°C and were calculated with the resonance frequency at 25°C as a reference.

The results were as shown in Table 1.

## Table 1

| Sample No. | Composition (mole%) | | | Di-electric constant εr | Q value | τf(ppm/°C) | |
|---|---|---|---|---|---|---|---|
| | MgO | La₂O₃ | TiO₂ | | | -40°C | +85°C |
| a 1 | 35.5 | 0.5 | 64.0 | 22.5 | 8500 | -37.0 | -39.5 |
| f 2 * | 34.0 | 1.0 | 65.0 | 23.4 | 4930 | -20.0 | -23.5 |
| * 3 | 26.2 | 8.8 | 65.0 | 32.7 | 300 | +11.7 | + 5.2 |
| * 4 | 17.5 | 17.5 | 65.0 | 37.1 | 80 | not measured | |
| * 5 | 8.8 | 26.2 | 65.0 | 43.2 | 70 | not measured | |
| 6 | 31.9 | 2.2 | 65.9 | 24.7 | 7110 | -21.0 | -24.0 |
| 7 | 30.9 | 3.2 | 65.9 | 25.5 | 5870 | -12.0 | -13.1 |
| g 8 | 28.7 | 5.4 | 65.9 | 31.3 | 4780 | +26.1 | +23.8 |
| * 9 | 33.3 | - | 66.7 | poorly sintered | | | |
| *10 | 25.0 | 8.3 | 66.7 | 41.0 | 3960 | +71.5 | +68.9 |
| 11 | 29.0 | 4.1 | 66.9 | 27.0 | 5110 | - 8.5 | - 8.3 |
| 12 | 27.2 | 5.0 | 67.8 | 27.6 | 4250 | - 3.0 | - 3.5 |
| 13 | 26.2 | 6.0 | 67.8 | 31.1 | 4030 | +21.0 | +22.5 |
| b14 | 16.0 | 16.0 | 68.0 | 53.1 | 1010 | +103.4 | +102.1 |

## Table 1 (continued)

| Sample No. | Composition (mole%) | | | Di-electric constant εr | Q value | τf(ppm/°C) | |
|---|---|---|---|---|---|---|---|
| | MgO | La$_2$O$_3$ | TiO$_2$ | | | −40°C | +85°C |
| k15 | 29.7 | 2.0 | 68.3 | 27.6 | 4220 | +27.5 | +20.2 |
| 16 | 26.4 | 4.9 | 68.7 | 27.0 | 6070 | − 9.1 | −10.6 |
| 17 | 25.4 | 5.9 | 68.7 | 28.3 | 4100 | − 1.7 | − 0.9 |
| 18 | 24.4 | 6.9 | 68.7 | 31.7 | 4360 | +17.3 | +16.8 |
| h19 | 23.4 | 7.9 | 68.7 | 33.1 | 3570 | +28.0 | +27.5 |
| 20 | 21.5 | 9.8 | 68.7 | 40.3 | 4350 | +60.0 | +58.2 |
| 21 | 19.5 | 11.8 | 68.7 | 44.7 | 3420 | +76.3 | +77.2 |
| 22 | 24.6 | 5.7 | 69.7 | 26.6 | 4090 | − 6.3 | − 6.8 |
| 23 | 23.7 | 6.6 | 69.7 | 28.9 | 4190 | − 0.1 | − 0.8 |
| 24 | 25.3 | 4.4 | 70.3 | 28.3 | 4700 | +28.2 | +21.7 |
| 25 | 22.0 | 7.4 | 70.6 | 29.5 | 4330 | + 0.2 | + 1.4 |
| 26 | 20.2 | 9.2 | 70.6 | 32.9 | 3270 | +23.8 | +24.0 |
| 27 | 16.5 | 12.9 | 70.6 | 42.8 | 2930 | +74.5 | +71.1 |
| e28 | 27.5 | 0.5 | 72.0 | 35.8 | 8930 | +158.5 | +130.1 |

Table 1 (continued)

| Sample No. | Composition (mole%) | | | Di-electric constant $\epsilon r$ | Q value | $\tau f(ppm/°C)$ | |
|---|---|---|---|---|---|---|---|
| | MgO | La$_2$O$_3$ | TiO$_2$ | | | −40°C | +85°C |
| 29 | 24.1 | 3.4 | 72.5 | 32.8 | 4360 | +93.2 | +82.6 |
| 30 | 20.6 | 6.9 | 72.5 | 31.0 | 3550 | +26.1 | +23.2 |
| i31 | 17.2 | 10.3 | 72.5 | 32.7 | 3170 | +20.5 | +21.3 |
| 32 | 13.7 | 13.8 | 72.5 | 43.0 | 2970 | +63.0 | +64.1 |
| 33 | 18.6 | 8.0 | 73.4 | 31.0 | 3720 | +23.5 | +19.9 |
| 34 | 19.2 | 6.4 | 74.4 | 33.7 | 4350 | +65.6 | +50.1 |
| 35 | 16.4 | 9.2 | 74.4 | 32.1 | 3570 | +22.5 | +21.7 |
| 36 | 15.4 | 9.8 | 74.8 | 32.1 | 2770 | +25.2 | +28.3 |
| *37 | 1.0 | 24.0 | 75.0 | 44.1 | 310 | not measured | |
| 38 | 17.8 | 5.9 | 76.3 | 38.1 | 4970 | +115.2 | +105.7 |
| 39 | 15.6 | 8.1 | 76.3 | 35.1 | 4080 | +77.6 | +67.2 |
| j40 | 12.2 | 11.5 | 76.3 | 33.0 | 2700 | +29.3 | +29.7 |
| 41 | 5.9 | 17.8 | 76.3 | 45.6 | 2310 | +70.1 | +74.2 |
| 42 | 7.1 | 14.3 | 78.6 | 34.4 | 2750 | +25.6 | +31.0 |

## Table 1 (continued)

| Sample No. | Composition (mole%) | | | Di-electric constant $\varepsilon r$ | Q value | $\tau f(ppm/°C)$ | |
|---|---|---|---|---|---|---|---|
| | MgO | La$_2$O$_3$ | TiO$_2$ | | | -40°C | +85°C |
| c43 | 1.0 | 20.0 | 79.0 | 42.1 | 2100 | +76.2 | +74.5 |
| *44 | 15.0 | 5.0 | 80.0 | 45.8 | 5680 | +212.7 | +184.2 |
| 45 | 10.0 | 10.0 | 80.0 | 40.6 | 4760 | +115.1 | +106.3 |
| 46 | 5.0 | 15.0 | 80.0 | 36.1 | 2430 | 46.7 | 50.6 |
| 47 | 1.3 | 18.7 | 80.0 | 40.6 | 2220 | 57.6 | 62.4 |
| *48 | - | 18.2 | 81.8 | poorly sintered | | | |
| d49 | 0.5 | 14.5 | 85.0 | 43.9 | 3780 | +120.3 | +107.5 |
| *50 | 9.4 | 3.1 | 87.5 | 64.3 | 9250 | +343.7 | +302.7 |
| *51 | 6.2 | 6.3 | 87.5 | 59.7 | 6720 | +285.6 | +255.1 |
| *52 | 1.6 | 10.9 | 87.5 | 53.0 | 4320 | +235.0 | +205.7 |

Samples marked with * are not included in the scope of the present invention.

As will be obvious from the above Table 1, the ceramic having compositions that lie within a range surrounded by the points a-b-c-d-e-a of the present invention all exhibited such dielectric characteristics as dielectric constants of greater than 20, Q values of greater than 1000 and τf of within 0 ± 170 ppm.

Furthermore, the compositions that lie within a range surrounded by f-g-h-i-j-k-f of Fig. 1 exhibited excellent dielectric characteristics, i.e., dielectric constants of greater than 22, Q values of greater than 2000 and τf of within 0 ± 30 ppm.

Embodiment 2

To the composition consisting of 15.5 mole% of MgO, 12 mole% of $La_2O_3$ and 72.5 mole% of $TiO_2$ was added $MnO_2$ in amounts as shown in Table 2 in order to evaluate the same characteristics as those of the embodiment 1. The results were as shown in Table 2.

Embodiment 3

To the samples of Table 1 was added $MnO_2$ in an amount of 0.2% by weight to evaluate the characteristics in the same manner. The results were as shown in Table 3.

Table 2

| Sample No. | Amount of $MnO_2$ (% by weight) | Dielectric constant $\varepsilon r$ | Q value | $\tau f$ (ppm/°C) | |
|---|---|---|---|---|---|
| | | | | -40°C | 85°C |
| 105 | -- | 38.7 | 3870 | +51.2 | +53.9 |
| 106 | 0.01 | 38.8 | 3920 | +51.9 | +54.1 |
| 107 | 0.1 | 48.8 | 5890 | +51.1 | +53.9 |
| 108 | 0.2 | 39.2 | 6120 | +50.9 | +53.8 |
| 109 | 1.0 | 38.5 | 5710 | +50.8 | +53.6 |
| 110 | 3.0 | 36.4 | 5340 | +51.7 | +54.7 |
| *111 | 4.0 | 35.2 | 5190 | +51.5 | +54.8 |

Samples marked with * are not included in the scope of the invention.

EP 0 454 172 B1

Table 3

| Sample No. | Composition (mole%) | | | Di-electric constant $\varepsilon r$ | Q value | $\tau f(ppm/°C)$ | |
|---|---|---|---|---|---|---|---|
| | MgO | La$_2$O$_3$ | TiO$_2$ | | | -40°C | +85°C |
| 53 | 35.5 | 0.5 | 64.0 | 22.2 | 12690 | -35.0 | -38.5 |
| 54 | 34.0 | 1.0 | 65.0 | 23.5 | 7090 | -20.6 | -24.1 |
| *55 | 26.2 | 8.8 | 65.0 | 32.6 | 350 | +11.0 | + 4.8 |
| *56 | 17.5 | 17.5 | 65.0 | 37.8 | 90 | not measured | |
| *57 | 8.8 | 26.2 | 65.0 | 43.0 | 80 | not measured | |
| 58 | 31.9 | 2.2 | 65.9 | 24.3 | 12700 | -19.9 | -22.1 |
| 59 | 30.9 | 3.2 | 65.9 | 25.8 | 9610 | -13.2 | -13.4 |
| 60 | 28.7 | 5.4 | 65.9 | 31.9 | 9230 | +28.1 | +25.8 |
| *61 | 33.3 | - | 66.7 | poorly sintered | | | |
| 62 | 25.0 | 8.3 | 66.7 | 40.5 | 7200 | +70.5 | +66.9 |
| 63 | 29.0 | 4.1 | 66.9 | 26.8 | 9340 | - 8.0 | - 8.4 |
| 64 | 27.2 | 5.0 | 67.8 | 27.6 | 7890 | - 3.6 | - 3.3 |
| 65 | 26.2 | 6.0 | 67.8 | 31.2 | 7640 | +20.0 | +21.7 |
| 66 | 16.0 | 16.0 | 68.0 | 52.9 | 1450 | +106.5 | +103.3 |

11

Table 3 (continued)

| Sample No. | Composition (mole%) | | | Dielectric constant $\varepsilon r$ | Q value | $\tau f$(ppm/°C) | |
|---|---|---|---|---|---|---|---|
| | MgO | La$_2$O$_3$ | TiO$_2$ | | | -40°C | +85°C |
| 67 | 29.7 | 2.0 | 68.3 | 27.1 | 7190 | +29.5 | +20.5 |
| 68 | 26.4 | 4.9 | 68.7 | 26.3 | 9060 | - 9.8 | -10.5 |
| 69 | 25.4 | 5.9 | 68.7 | 28.4 | 7790 | - 1.1 | - 0.6 |
| 70 | 24.4 | 6.9 | 68.7 | 31.2 | 7650 | +16.3 | +16.2 |
| 71 | 23.4 | 7.9 | 68.7 | 33.5 | 6200 | +29.2 | +28.4 |
| 72 | 21.5 | 9.8 | 68.7 | 40.0 | 7040 | +63.0 | +61.2 |
| 73 | 19.5 | 11.8 | 68.7 | 44.0 | 6020 | +78.7 | +77.9 |
| 74 | 24.6 | 5.7 | 69.7 | 26.9 | 7840 | - 6.4 | - 7.1 |
| 75 | 23.7 | 6.6 | 69.7 | 28.7 | 7580 | - 0.2 | + 0.7 |
| 76 | 25.3 | 4.4 | 70.3 | 28.4 | 7000 | +26.2 | +19.7 |
| 77 | 22.0 | 7.4 | 70.6 | 29.1 | 6980 | + 0.3 | + 1.6 |
| 78 | 20.2 | 9.2 | 70.6 | 33.4 | 5400 | +25.0 | +25.8 |
| 79 | 16.5 | 12.9 | 70.6 | 43.4 | 5890 | +72.0 | +71.5 |
| 80 | 27.5 | 0.5 | 72.0 | 36.1 | 15110 | +166.3 | +136.5 |

## Table 3 (continued)

| Sample No. | Composition (mole%) | | | Di-electric constant $\varepsilon r$ | Q value | $\gamma f(ppm/°C)$ | |
|---|---|---|---|---|---|---|---|
| | MgO | La$_2$O$_3$ | TiO$_2$ | | | -40°C | +85°C |
| 81 | 24.1 | 3.4 | 72.5 | 33.1 | 8580 | +97.8 | +80.7 |
| 82 | 20.6 | 6.9 | 72.5 | 30.3 | 5520 | +27.6 | +23.6 |
| 83 | 17.2 | 10.3 | 72.5 | 33.6 | 5330 | +21.5 | +23.2 |
| 84 | 13.7 | 13.8 | 72.5 | 42.7 | 5030 | +64.0 | +65.4 |
| 85 | 18.6 | 8.0 | 73.4 | 30.5 | 6890 | +21.5 | +19.7 |
| 86 | 19.2 | 6.4 | 74.4 | 33.5 | 8830 | +70.6 | +52.4 |
| 87 | 16.4 | 9.2 | 74.4 | 31.5 | 6360 | +23.1 | +22.7 |
| 88 | 15.4 | 9.8 | 74.8 | 32.1 | 5000 | +27.7 | +29.7 |
| *89 | 1.0 | 24.0 | 75.0 | 43.8 | 420 | not measured | |
| 90 | 17.8 | 5.9 | 76.3 | 37.5 | 8040 | +122.1 | +103.1 |
| 91 | 15.6 | 8.1 | 76.3 | 35.6 | 7160 | +80.7 | +69.5 |
| 92 | 12.2 | 11.5 | 76.3 | 33.0 | 4830 | +31.4 | +32.2 |
| 93 | 5.9 | 17.8 | 76.3 | 46.2 | 4440 | +74.7 | +77.1 |
| 94 | 7.1 | 14.3 | 78.6 | 34.4 | 5400 | +26.1 | +30.6 |

Table 3 (continued)

| Sample No. | Composition (mole%) | | | Di-electric constant εr | Q value | τf(ppm/°C) | |
|---|---|---|---|---|---|---|---|
| | MgO | La₂O₃ | TiO₂ | | | -40°C | +85°C |
| 95 | 1.0 | 20.0 | 79.0 | 41.5 | 3900 | -74.2 | -73.3 |
| *96 | 15.0 | 5.0 | 80.0 | 45.4 | 9420 | +209.7 | +180.1 |
| 97 | 10.0 | 10.0 | 80.0 | 40.4 | 6610 | +119.1 | +107.8 |
| 98 | 5.0 | 15.0 | 80.0 | 36.6 | 4920 | 48.9 | 50.1 |
| 99 | 1.3 | 18.7 | 80.0 | 40.6 | 4120 | 53.8 | 61.3 |
| *100 | - | 18.2 | 81.8 | poorly sintered | | | |
| 101 | 0.5 | 14.5 | 85.0 | 43.5 | 6360 | +125.9 | +108.2 |
| *102 | 9.4 | 3.1 | 87.5 | 64.3 | 14050 | +354.9 | +306.9 |
| *103 | 6.2 | 6.3 | 87.5 | 59.1 | 10340 | +297.5 | +257.4 |
| *104 | 1.6 | 10.9 | 87.5 | 53.2 | 8560 | +229.5 | +204.8 |

Samples marked with * are not included in the scope of the present invention.

From Tables 2 and 3, an increase in the Q value could be confirmed when $MnO_2$ was added in an amount of 0.01% by weight, and the Q value could be nearly doubled when $MnO_2$ was added in an amount of 0.2% by weight compared with samples to which no $MnO_2$ was added. When $MnO_2$ was added in an amount in excess of 4% by weight, however, the dielectric constant dropped conspicuously. Particularly preferred, therefore, $MnO_2$ should be added in an amount of 0.1 to 1% by weight.

Embodiment 4

The samples Nos. 2, 3, 4, 10, 17, 19, 24, 29, 30, 31, 32, 38, 40, 42, 45 and 52 of Table 1 were examined for their crystalline phases constituting the ceramics by the powder X-ray diffraction analysis. The results were as shown in Table 4.

Table 4

| Sample No. | $TiO_2$ | $MgTi_2O_5$ | $La_4Ti_9O_{24}$ | $La_{0.66}TiO_{2.993}$ | $La_2Ti_2O_7$ |
|---|---|---|---|---|---|
| *2 | | ○ | | | |
| *3 | | ○ | | ○ | ○ |
| *4 | | ○ | | ○ | ○ |
| *10 | | ○ | | ○ | |
| 17 | | ○ | ○ | | |
| 19 | | ○ | ○ | ○ | |
| 24 | | ○ | ○ | | |
| 29 | ○ | ○ | ○ | | |
| 30 | | ○ | ○ | | |
| 31 | | ○ | ○ | ○ | |
| 32 | | ○ | ○ | ○ | |
| 38 | ○ | ○ | ○ | | |
| 40 | | ○ | ○ | | |
| 42 | | ○ | ○ | | |
| 45 | ○ | ○ | ○ | | |
| *52 | ○ | | ○ | | |

Samples marked with * are not included in the scope of the invention.

It will be understood from Table 4 that the dielectric ceramic constituted according to the present invention assumes a mixed form which includes at least one crystalline phase among five crystalline phases consisting of $TiO_2$, $La_4Ti_9O_{24}$, $MgTi_2O_5$, $La_{0.66}TiO_{2.993}$ and $La_2Ti_2O_7$. There is a tendency that when $La_2O_3$ is added in large amounts, $La_2Ti_2O_7$ is precipitated as a main crystalline phase. This crystal, however, has a small Q value, and the ceramic as a result exhibits not much large Q value. To obtain a high Q value, therefore, the amount of $La_2O_3$ is decreased, and $La_4Ti_9O_{24}$, $La_{0.66}TiO_{2.993}$ or $MgTi_2O_5$ that exhibits high Q value by itself is added as main crystalline phase. Moreover, $MgTi_2O_5$ is a crystalline phase having small τf which is indispensable for the composition system of the present invention to exhibit its characterics. On the other hand, $TiO_2$ causes τf to increase but presents no problem when it is used in small amounts. $TiO_2$ which is detected in small amounts in the composition of the present invention affects τf very little.

## Claims

1. A dielectric ceramic composition for resonator use which has a composition expressed by the following formula (A) based on oxides of three components,

$$xMgO \cdot yLa_2O_3 \cdot zTiO_2 \qquad (A)$$

wherein x, y and z are numerals which represent mole % of said components and further satisfy the equation and inequalities,

$$x + y + z = 100 \qquad (1)$$

$$y \leq -0.79487x + 28.718 \qquad (2)$$

$$y \leq -0.26667x + 20.267 \qquad (3)$$

$$y \leq 11x + 9 \qquad (4)$$

$$y \geq -0.51852x + 14.759 \qquad (5)$$

and

$$y \geq 0.5 \qquad (6)$$

and said ceramic composition contains a crystalline phase, as a main crystalline phase, consisting of $La_4Ti_9O_{24}$ and $MgTi_2O_5$ in combination and has a Q value of greater than 1000 in microwave frequency bands.

2. A dielectric ceramic composition according to claim 1, wherein x, y and z in said formula (A) are numerals that satisfy the following equation and inequalities,

$$x + y + z = 100 \qquad (1)$$

$$y \leq -0.8302x + 29.2268 \qquad (7)$$

$$y \leq -0.4717x + 19.9378 \qquad (8)$$

$$y \leq -0.3871x + 16.9581 \qquad (9)$$

$$y \geq -0.24x + 14.428 \qquad (10)$$

$$y \geq -0.5429x + 18.1234 \qquad (11)$$

and

$$y \geq -0.2326x + 8.9082 \qquad (12).$$

3. A dielectric ceramic composition for resonator use which has a composition, as main components, expressed by the following formula (A) based on oxides of three components,

$$xMgO{\cdot}yLa_2O_3{\cdot}zTiO_2 \qquad (A)$$

wherein x, y and z are numerals which represent mole % of said components and further satisfy the equation and inequalities,

$$x + y + z = 100 \qquad (1)$$

$$y \leq -0.79487x + 28.718 \qquad (2)$$

$$y \leq -0.26667x + 20.267 \tag{3}$$

$$y \leq 11x + 9 \tag{4}$$

$$y \geq -0.51852x + 14.759 \tag{5}$$

and

$$y \geq 0.5 \tag{6}$$

and which contains 0.01 to 3 % by weight of $MnO_2$ with respect to said main components and said ceramic composition contains a crystalline phase, as a main crystalline phase, consisting of $La_4Ti_9O_{24}$ and $MgTi_2O_5$ in combination, and has a Q value of greater than 1000 in microwave frequency bands.

4. A dielectric ceramic composition according to claim 3, wherein x, y and z in said formula (A) are numerals that satisfy the following equation and inequalities,

$$x + y + z = 100 \tag{1}$$

$$y \leq -0.8302x + 29.2268 \tag{7}$$

$$y \leq -0.4717x + 19.9378 \tag{8}$$

$$y \leq -0.3871x + 16.9581 \tag{9}$$

$$y \geq -0.24x + 14.428 \tag{10}$$

$$y \geq -0.5429x + 18.1234 \tag{11}$$

and

$$y \geq -0.2326x + 8.9082 \tag{12}.$$

5. A dielectric ceramic composition according to claim 3, wherein $MnO_2$ is contained in an amount of 0.1 to 1 % by weight with respect to the main components.

**Patentansprüche**

1. Dielektrische keramische Zusammensetzung zur Verwendung als Resonator, welche eine Zusammensetzung gemäß der nachfolgenden Formel (A) basierend auf den Oxiden dieser drei Komponenten aufweist,

$$xMgO \cdot yLa_2O_3 \cdot zTiO_2 \tag{A},$$

worin x, y und z Zahlen sind, welche Mol-% der Komponenten darstellen und weiter der(n) folgenden Gleichung und Ungleichungen genügen,

$$x + y + z = 100 \qquad (1)$$

$$y \leq -0{,}79487x + 28{,}718 \qquad (2)$$

$$y \leq -0{,}26667x + 20{,}267 \qquad (3)$$

$$y \leq 11x + 9 \qquad (4)$$

$$y \geq -0{,}51852x + 14{,}759 \qquad (5),$$

und

$$y \geq 0{,}5 \qquad (6)$$

und die keramische Zusammensetzung als Hauptkristallphase eine $La_4Ti_9O_{24}$ und $MgTi_2O_5$ in Kombination enthaltende Kristallphase enthält und einen Q-Wert von größer als 1000 in Mikrowellenfrequenzbändern hat.

2. Dielektrische keramische Zusammensetzung nach Anspruch 1, worin x, y und z in der Formel (A) Zahlen sind, die der(n) folgenden Gleichung und Ungleichungen genügen,

$$x + y + z = 100 \qquad (1)$$

$$y \leq -0{,}8302x + 29{,}2268 \qquad (7)$$

$$y \leq -0{,}4717x + 19{,}9378 \qquad (8)$$

$$y \leq -0{,}3871x + 16{,}9581 \qquad (9)$$

$$y \geq -0{,}24x + 14{,}428 \qquad (10)$$

$$y \geq -0{,}5429x + 18{,}1234 \qquad (11),$$

und

$$y \geq -0{,}2326x + 8{,}9082 \qquad (12).$$

3. Dielektrische keramische Zusammensetzung zur Verwendung als Resonator, welche als Hauptkomponente eine durch die folgende Formel (A) ausgedrückte Zusammensetzung basierend auf den Oxiden dieser drei Komponenten hat,

$$xMgO \cdot yLa_2O_3 \cdot zTiO_2 \qquad (A),$$

worin x, y und z Zahlen sind, welche Mol-% der Komponenten darstellen und weiter der(n) folgenden Gleichung und Ungleichungen genügen,

$$x + y + z = 100 \tag{1}$$

$$y \leq -0{,}79487x + 28{,}718 \tag{2}$$

$$y \leq -0{,}26667x + 20{,}267 \tag{3}$$

$$y \leq 11x + 9 \tag{4}$$

$$y \geq -0{,}51852x + 14{,}759 \tag{5},$$

und

$$y \geq 0{,}5 \tag{6},$$

und welche 0,01 bis 3 Gew.-% $MnO_2$ in Bezug auf die Hauptkomponenten enthält und die keramische Zusammensetzung als Hauptkristallphase $La_4Ti_9O_{24}$ und $MgTi_2O_5$ in Kombination enthaltende Kristallphase enthält und einen Q-Wert von größer als 1000 in Mikrowellenfrequenzbändern hat.

4. Dielektrische keramische Zusammensetzung nach Anspruch 3, worin x, y und z in der Formel (A) Zahlen sind, die der(n) folgenden Gleichung und Ungleichungen genügen,

$$x + y + z = 100 \tag{1}$$

$$y \leq -0{,}8302x + 29{,}2268 \tag{7}$$

$$y \leq -0{,}4717x + 19{,}9378 \tag{8}$$

$$y \leq -0{,}3871x + 16{,}9581 \tag{9}$$

$$y \geq -0{,}24x + 14{,}428 \tag{10}$$

$$y \geq -0{,}5429x + 18{,}1234 \tag{11},$$

und

$$y \geq -0{,}2326x + 8{,}9082 \tag{12}.$$

5. Dielektrische Zusammensetzung nach Anspruch 3, worin $MnO_2$ in einer Menge von 0,1 bis 1 Gew.-%, bezogen auf die Hauptkomponenten, enthalten ist.


**Revendications**

1. Une composition céramique diélectrique pour une utilisation comme résonateur qui présente une composition exprimée par la formule suivante (A) calculée sur les oxydes de trois composants:

$$xMgO \cdot yLa_2O_3 \cdot zTiO_2 \tag{A}$$

dans laquelle x, y et z sont des nombres qui représentent les moles % desdits composants et satisfont, en outre, l'équation et les relations:

$$x + y + z = 100 \tag{1}$$

$$y \leq -0{,}79487x + 28{,}718 \tag{2}$$

$$y \leq -0{,}26667x + 20{,}267 \tag{3}$$

$$y \leq 11x + 9 \tag{4}$$

$$y \geq -0{,}51852x + 14{,}759 \tag{5}$$

et

$$y \geq 0{,}5 \tag{6}$$

et ladite composition céramique renferme une phase cristalline, en tant que phase cristalline principale, se composant de $La_4Ti_9O_{24}$ et $MgTi_2O_5$ en combinaison et a une valeur Q supérieure à 1000 dans les bandes de fréquence de micro-ondes.

2. Une composition céramique diélectrique selon la revendication 1, dans laquelle x, y et z dans ladite formule (A) sont des nombres qui satisfont l'équation et les relations suivantes:

$$x + y + z = 100 \tag{1}$$

$$y \leq -0{,}8302x + 29{,}2268 \tag{7}$$

$$y \leq -0{,}4717x + 19{,}9378 \tag{8}$$

$$y \leq -0{,}3871x + 16{,}9581 \tag{9}$$

$$y \geq -0{,}24x + 14{,}428 \tag{10}$$

$$y \geq -0{,}5429x + 18{,}1234 \tag{11}$$

et

$$y \geq -0{,}2326x + 8{,}9082 \tag{12}.$$

3. Une composition céramique diélectrique pour une utilisation comme résonateur qui présente une composition, comme composants principaux, exprimée par la formule suivante (A) calculée sur les oxydes de trois composants:

$$xMgO \cdot yLa_2O_3 \cdot zTiO_2 \qquad\qquad (A)$$

dans laquelle x, y et z sont des nombres qui représentent les moles % desdits composants et satisfont, en outre, l'équation et les relations:

$$x + y + z = 100 \qquad\qquad (1)$$

$$y \leq - 0,79487x + 28,718 \qquad\qquad (2)$$

$$y \leq - 0,26667x + 20,267 \qquad\qquad (3)$$

$$y \leq 11x + 9 \qquad\qquad (4)$$

$$y \geq - 0,51852x + 14,759 \qquad\qquad (5)$$

et

$$y \geq 0,5 \qquad\qquad (6)$$

et qui contient 0,01 à 3% en poids de $MnO_2$ par rapport auxdits composants principaux et ladite composition céramique renferme une phase cristalline, en tant que phase cristalline principale, se composant de $La_4Ti_9O_{24}$ et $MgTi_2O_5$ en combinaison et a une valeur Q supérieure à 1000 dans les bandes de fréquence de micro-ondes.

4. Une composition céramique diélectrique selon la revendication 3, dans laquelle x, y et z dans ladite formule (A) sont des nombres qui satisfont l'équation et les relations suivantes:

$$x + y + z = 100 \qquad\qquad (1)$$

$$y \leq - 0,8302x + 29,2268 \qquad\qquad (7)$$

$$y \leq - 0,4717x + 19,9378 \qquad\qquad (8)$$

$$y \leq - 0,3871x + 16,9581 \qquad\qquad (9)$$

$$y \geq - 0,24x + 14,428 \qquad\qquad (10)$$

$$y \geq - 0,5429x + 18,1234 \qquad\qquad (11)$$

et

$$y \geq - 0,2326x + 8,9082 \qquad\qquad (12).$$

5. Une composition céramique diélectrique selon la revendication 3, dans laquelle $MnO_2$ représente une quantité de 0,1 à 1% en poids par rapport aux composants principaux.

# FIG.1